**Europäisches Patentamt**

**European Patent Office**

**Office européen des brevets**

(19)

(11) Veröffentlichungsnummer: **0 025 029**
**B1**

(12) **EUROPÄISCHE PATENTSCHRIFT**

(45) Veröffentlichungstag der Patentschrift:
**15.02.84**

(51) Int. Cl.³: **G 01 D 5/24**, G 01 R 27/26

(21) Anmeldenummer: **80890094.8**

(22) Anmeldetag: **29.08.80**

(54) **Kapazitive Messbrückenanordnung.**

(30) Priorität: **29.08.79 AT 5774/79**

(43) Veröffentlichungstag der Anmeldung:
**11.03.81 Patentblatt 81/10**

(45) Bekanntmachung des Hinweises auf die Patenterteilung:
**15.02.84 Patentblatt 84/7**

(84) Benannte Vertragsstaaten:
**AT CH DE FR GB IT LI**

(56) Entgegenhaltungen:
**DE - A - 2 443 886**
**FR - A - 2 373 038**
**US - A - 3 519 923**

(73) Patentinhaber: **List, Hans, Heinrichstrasse 126,**
**A-8010 Graz (AT)**

(72) Erfinder: **Fredericks, George E., Stiftingtalstrasse 164/B,**
**A-8010 Graz (AT)**
Erfinder: **Preschern, Horst, Wagnerstrasse 19,**
**A-8430 Leibnitz (AT)**

(74) Vertreter: **Krause, Walter, Dr. Dipl.-Ing.,**
**Margaretenstrasse 21, A-1040 Wien (AT)**

## Kapazitive Messbrückenanordnung

Die Erfindung bezieht sich auf eine kapazitive Messbrückenanordnung, insbesondere für kleine Kapazitätswerte, mit
- einer Messbrücke aus zwei gleichartig aufgebauten Brückenzweigen, die einander parallel geschaltet sind und jeweils einen Kondensator enthalten, von denen einer oder beide veränderlich sind,
- einer Gleichspannungsquelle zur Lieferung einer Versorgungsspannung
- einem Oszillator zur Erzeugung einer Rechteckwellenspannung,
- zwei vom Oszillator gesteuerten Schaltelementen, in Abhängigkeit von deren Schaltzustand die Kondensatoren aus einer Stromquelle geladen oder entladen werden,
- einem Differenzverstärker zur Erzeugung eines dem Unterschied in den Ladeströmen der beiden Kondensatoren entsprechenden Ausgangssignals, das dem Unterschied in den Kapazitätswerten der beiden Kondensatoren entspricht, wobei die beiden Eingänge des Differenzverstärkers mit dem Ausgang der Messbrücke in Verbindung stehen.

Eine derartige Messbrücke ist durch die US-A 3 519 923 bekannt geworden. Bei dieser ist die Gleichspannungsquelle mit den beiden Brückenzweigen über ein von dem Oszillator gesteuertes Schaltelement verbunden, wobei die von diesem Schaltelement abgehende Leitung über das zweite vom Oszillator gesteuerte Schaltelement mit Masse bzw. dem zweiten Pol der Gleichstromquelle verbindbar ist. Dabei werden beide Schaltelemente im Gegentakt betätigt. Der Nachteil dieses Messwandlers besteht darin, dass er keine Rückkopplung aufweist und eine solche mit einfachen Mitteln auch nicht möglich ist. Ausserdem liefert dieser Messwandler nur bei einer unsymmetrischen Brücke ein Ausgangssignal und muss daher, um Fremdeinflüsse weitgehend zu vermeiden, samt den Anschlussleitungen geschirmt werden. Weiters geht jede Drift eines Bauteils in das Ausgangssignal ein, wodurch ein häufiges Justieren erforderlich ist.

Eine weitere Messbrücke ist z.B. durch die DE-A 2 641 758 bekannt geworden. Bei dieser bekannten Messbrücke sind die beiden Brückenzweige, die je einen Verstärker aufweisen, in deren Steuerkreis je ein Kondensator bzw. eine Parallelschaltung von Kondensatoren und in deren Hauptstromkreisen je eine Widerstandskombination vorhanden ist, mit ihren Endpunkten miteinander verbunden und an einen Oszillator angeschlossen. Die Auswertung von Kapazitätsänderungen eines oder zweier der in verschiedenen Brückenzweigen angeordneten Kondensatoren erfolgt im bekannten Falle über die als Ladungsverstärker wirkenden Verstärker – die z.B. als Gleichstrom-Operationsverstärker mit einer kapazitiven Rückkopplung ausgebildet sein und eine Ausgangsspannung erzeugen können, die unmittelbar der Ladungsänderung an den Eingangsanschlüssen proportional ist – und den deren Ausgangssignale auswertenden Differenzverstärker, welchem Filter und ein Phasendemodulator nachgeschaltet sind, dessen zweiter Eingang mit dem Oszillator verbunden ist, sowie einem dem Phasendemodulator nachgeschalteten Differenzverstärker und einem Bandfilter. Die Ausgangsspannung des Bandfilters ist dabei über einen Analog-Multiplizierer auf einen Brückenzweig rückgekoppelt, der diesem vorgeschaltet ist.

Der Nachteil dieser bekannten Messbrücke liegt darin, dass die einzelnen Teile der Schaltung sehr aufwendig sind und sich daher ein sehr hoher Aufwand ergibt, wozu auch wesentlich der Analog-Multiplizierer beiträgt. Ein weiterer Nachteil bei dieser Messbrücke, die nach der Trägerfrequenz-Methode arbeitet, ergibt sich auch dadurch, dass ein Sinusgenerator erforderlich ist, falls etwas höhere Ansprüche gestellt werden und daraus ebenfalls ein erheblicher Aufwand resultiert.

Ziel der Erfindung ist es, eine Messbrücke der eingangs erwähnten Art vorzuschlagen, die sich durch einen einfachen Aufbau auszeichnet und trotzdem ein hohes Mass an Stabilität aufweist.

Erfindungsgemäss wird dies dadurch erreicht, dass
- jedes der beiden Schaltelemente in Reihe mit jeweils einem der beiden Brückenzweige geschaltet ist,
- dass an den Verbindungspunkt jedes der Brückenzweige mit dem zugehörigen Schaltelement jeweils eine Potentialquelle über jeweils ein passives Bauelement angeschlossen ist, wobei die eine der Potentialquellen von einem lediglich passive Bauelemente aufweisenden Rückkopplungskreis gebildet ist, der vom Ausgang des Differenzverstärkers zum betreffenden Verbindungspunkt führt, während die andere Potentialquelle einen festen Potentialwert oder ein zum Ausgangssignal des Differenzverstärkers inverses Potential liefert, und
- dass den beiden Eingängen des Differenzverstärkers jeweils eine Glättungsschaltung vorgeschaltet ist.

Durch den vom Oszillator gelieferten Impulszug wird über die Schaltelemente das an den Brückenzweigen anstehende Potential entsprechend dem Impulszug geändert, wobei es in weiterer Folge zu Potentialänderungen auf den Elektroden der Kondensatoren kommt und sich entsprechend den Kapazitätswerten der Kondensatoren Umladungsströme in den Brückenzweigen ausbilden. Unterschiede in den Strömen der Brückenzweige oder Spannungsunterschiede an bestimmten Punkten der beiden Brückenzweige werden durch den Differenzverstärker verstärkt und über den Rückkoppelkreis auf einen Brückenzweig rückgekoppelt und damit das Ausmass der Potentialsprünge aufgrund des vom Oszillator kommenden Impulszuges in einem Brückenzweig beeinflusst, wogegen der zweite Brückenzweig während der Sperrzeit der Schaltelemente von einem festen Potential oder dem Differenzausgang des Differenzverstärkers beeinflusst ist.

Dadurch ist es möglich, mit einem sehr einfachen Aufbau das Auslangen zu finden, wobei durch eine entsprechend starke Rückkopplung eine sehr hohe Stabilität und Linearität erreicht wird.

Nach einer Ausgestaltung der Erfindung ist vorgesehen, dass die Schaltelemente durch Dioden gebildet sind und die Rechteckwellenspannung zwischen Werten schwankt, die über und unter den um die Durchlassspannung der Dioden verschobenen Potentialen der Potentialquellen liegen, wodurch sich ein besonders einfacher Aufbau ergibt.

Grundsätzlich ist es aber auch möglich, statt der Dioden auch Transistoren oder gesteuerte Gleichrichter an den einen Endpunkten der Brückenzweige vorzusehen und an eine als Hilfsspannung dienende Gleichspannungsquelle anzuschliessen, wobei dann diese Bauelemente von einer weiteren einen aus Rechteckimpulsen bestehenden Impulszug liefernden Hilfsspannungsquelle angesteuert werden. Damit wird ebenfalls ein alternierendes Ändern der Ladungen der Kondensatoren der Brücke erzielt, wobei sich Änderungen in der Kapazität eines Kondensators ebenfalls, wie bereits beschrieben, in einer Änderung des Verhältnisses der durch die beiden Brückenzweige fliessenden Ströme auswirkt, was über die Verstärker und den Differenzverstärker zu einer Änderung von dessen Ausgangsspannung führt.

Da die Brücke bzw. die Verstärker praktisch im Rhythmus der Durchschaltung der die beiden Brückenzweige mit der Hilfsspannungsquelle verbindenden Schaltelemente aus- und eingeschaltet werden, ergeben sich an den Ausgängen der Verstärker bzw. an den Eingängen des Differenzverstärkers hohe Gleichtaktsprünge. Um dies zu vermeiden, ist vorteilhafterweise vorgesehen, dass die Eingänge des Differenzverstärkers mit je einem Kondensator verbunden sind, wobei die beiden anderen Elektroden dieser Kondensatoren gemeinsam an einem festen Potential liegen, wodurch die Gleichtaktsprünge sehr stark gedämpft bzw. geglättet werden und daher mit einem einfacher aufgebauten Differenzverstärker das Auslangen gefunden wird.

Eine besonders weitgehende Unterdrückung der Gleichtaktsprünge ergibt sich, wenn die Eingänge des Differenzverstärkers mit je einem Kondensator verbunden sind, wobei die beiden anderen Elektroden dieser Kondensatoren gemeinsam an einem an einem festen Potential liegenden Potentialteiler angeschlossen sind, dessen Mittelanschluss über eine Diode mit dem Oszillator verbunden ist. Durch diese Massnahme ist es möglich, bereits mit sehr kleinen Kondensatoren eine sehr hohe Dämpfung der Gleichtaktsprünge zu erreichen.

Bei einer bevorzugten Ausführungsform der Erfindung ist vorgesehen, dass an den Verbindungspunkten der beiden Kondensatoren mit den übrigen, vorzugsweise aus je einem weiteren Kondensator bestehenden Bauteilen der Brückenzweige die Steuereingänge zweier vorzugsweise durch Transistoren gebildeten Verstärker angeschlossen sind, welche mit ihren Ausgängen mit den Glättungsschaltungen verbunden sind. Dadurch ist es möglich, kleine Kondensatoren zu verwenden. Damit ergibt sich die Möglichkeit, eine vom Oszillator gelieferte Hilfsspannung mit hoher Frequenz zu verwenden, wodurch auch sehr rasch erfolgende Kapazitätsänderungen erfassbar werden.

Nach einem weiteren Merkmal der Erfindung ist vorgesehen, dass die mit den Steuereingängen der Verstärker verbundenen Verbindungspunkte der beiden Brückenzweige über in Sperrrichtung gepolte Dioden und zu diesen parallel geschaltete Widerstände mit einem festen Potential der Gleichspannungsquelle verbunden sind. Auf diese Weise wird eine Begrenzung der Invers-Emitter-Basisspannungen der Transistoren erreicht, wobei durch eine Parallelschaltung von Widerständen zu diesen Begrenzungsdioden, deren allfällige Unterschiede in deren Charakteristik praktisch ohne Einfluss auf die Messung bleiben.

Zur Erhöhung der Linearität zwischen dem Ausgangssignal der Messbrückenanordnung bzw. des Differenzverstärkers und der Kapazität ist es vorteilhaft, wenn die Emitter der die Verstärker bildenden Transistoren über je einen Widerstand mit einem an einem festen Potential der Gleichspannungsquelle angeschlossenen weiteren Widerstand verbunden sind.

Bei einer erfindungsgemässen Messbrückenanordnung kann weiters vorgesehen sein, dass in jedem Brückenzweig ein von einem Transistor gebildeter Verstärker angeordnet ist, der Differenzverstärker eingangsseitig mit den Hauptstromkreisen dieser Transistoren verbunden ist, die Emitter der Transistoren mit Widerständen verbunden sind, die anderseits mit den beiden Kondensatoren und mit Entladewiderständen verbunden sind, und die Emitter und die Basen dieser Transistoren über Widerstände mit einem festen Potential der Gleichspannungsquelle verbunden sind, wobei die Basen der Transistoren mit den Schaltelementen über jeweils einen weiteren Kondensator der Brückenzweige verbunden sind. Bei solchen Messbrücken ist es möglich, sehr kleine Kapazitäten im Basiskreis der Transistoren in Verbindung mit niederohmigen Entladewiderständen vorzusehen, so dass sich kleine Zeitkonstanten ergeben und an die Schaltelemente eine Rechteckimpulsfolge mit hoher Frequenz angelegt werden kann. Dadurch ist es möglich, auch sehr kurzzeitige Kapazitätsänderungen festzustellen, insbesondere wenn einer oder zwei variable Kondensatoren im Hauptstromkreis der Transistoren liegen.

Bei einer derartigen Messbrückenanordnung ist es weiters vorteilhaft, dass die einen Elektroden der im Hauptstromkreis der Verstärker liegenden Kondensatoren der Brückenzweige an einem gemeinsamen festen Potential liegen und dass die Entladewiderstände jeweils an einem gemeinsamen festen Potential liegen, das negativer ist als jenes der Eingänge des Differenzverstärkers. Durch die letztere Massnahme wird erreicht, dass das Niveau der Gleichtaktspannung an den Eingängen des Differenzverstärkers genügend weit von den Potentialen seiner Versorgungsspannung entfernt bleibt. Ein besonders hohes Mass an Linearität zwischen der Ausgangsspannung und der zu messenden Kapazität ergibt sich, wenn die andere Potentialquelle von einer an den Ausgang des Differenzverstärkers angeschlossenen Inverterschaltung gebildet ist. Gleiches lässt sich auch durch Rückkopplung eines Differenzausganges des Differenzverstärkers auf den zweiten Brückenzweig über passive Bauteile erreichen.

Die Erfindung wird nun anhand der Zeichnung näher erläutert. Dabei zeigen:

Fig. 1 eine Ausführungsform mit Spannungsabgriff an den Brückenzweigen und

Fig. 2 eine Ausführungsform mit in den Brückenzweigen eingeschalteten Verstärkern.

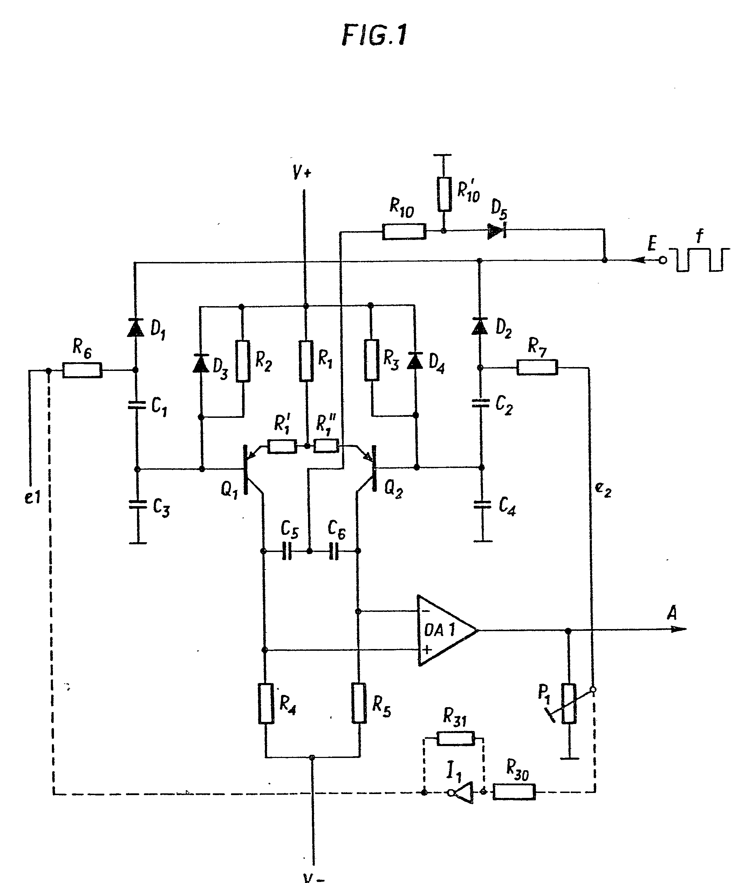

Bei der Ausführungsform gemäss Fig. 1 werden die Brückenzweige durch die Kondensatoren $C_1$, $C_3$ bzw. $C_2$, $C_4$ gebildet, wobei die einen Elektroden der Kondensatoren $C_3$, $C_4$ gemeinsam auf einem festen Potential, z.B. Erde, liegen. Die beiden anderen Enden der beiden Brückenzweige sind über den Widerstand $R_6$ an ein Potential $e_1$ bzw. den Widerstand $R_7$ an ein Potential $e_2$ gelegt, wobei das Potential $e_2$ zwecks Rückkopplung über das Potentiometer $P_1$ von der Ausgangsspannung der Messbrücke abgenommen ist. Weiters sind diese Enden der Brückenzweige über die Dioden $D_1$ und $D_2$ mit einer nicht dargestellten Hilfsspannungsquelle verbunden, welche einen aus Rechteckimpulsen bestehenden Impulszug f liefert.

Die Verbindungspunkte der beiden je einen Brückenzweig bildenden Kondensatoren $C_3$, $C_1$ bzw. $C_2$, $C_4$ sind mit den Basen der beiden vorzugsweise in einem integrierten Pärchen zusammengefassten Transistoren $Q_1$, $Q_2$ verbunden, welche als Verstärker dienen. Weiters sind diese Verbindungspunkte über Dioden $D_3$, $D_4$ und zu diesen parallel geschalteten Widerständen $R_2$, $R_3$ an ein festes Potential V+ gelegt. An diesem Potential liegt auch der Widerstand $R_1$, an dem die Emitter der beiden Transistoren $Q_1$, $Q_2$ über je einen weiteren Emitterwiderstand $R_1'$, $R_1''$ angeschlossen sind. Der gemeinsame Verbindungspunkt zweier zur Gleichtaktsprung-Begrenzung des Differenzverstärkers $OA_1$ dienenden Kondensatoren $C_5$, $C_6$, welche mit den Kollektoren der Transistoren $Q_1$, $Q_2$ bzw. den Eingängen des Differenzverstärkers $OA_1$ verbunden sind, ist über den Widerstand $R_{10}$ und die Diode $D_5$ mit dem Punkt E, an dem die Rechteckwellenspannung f liegt, bzw. über die Widerstände $R_{10}$ und $R_{10}'$ mit Masse verbunden. Weiters sind die Kollektoren der Transistoren $Q_1$, $Q_2$ bzw. die Eingänge des Differenzverstärkers $OA_1$ mit Widerständen $R_4$, $R_5$ verbunden, die gemeinsam an einem festen Potential V– liegen.

Diese Schaltung hat zwei Betriebszustände: Der erste Zustand, der im folgenden immer als Grundstellung bezeichnet wird, kommt vor, wenn der Impulseingang hoch ist («hoch» bedeutet eine Spannung positiver als das Potential $e_1$ und das Potential $e_2$). Nach einiger Zeit in diesem Zustand fliesst praktisch kein Strom in die Kapazitätsbrücke. Die Dioden $D_1$ und $D_2$ befinden sich im Sperrzustand. Die eine Elektrode von $C_1$ liegt auf dem Potential $e_1$, die eine Elektrode von $C_2$ liegt auf Potential $e_2$. Das Potential $e_2$ wird bestimmt durch die Ausgangsspannung und die Einstellung des Potentiometers $P_1$. Die Brückenmittelpunkte und daher auch die Basen der zwei Transistoren $Q_1$, $Q_2$ liegen auf dem Potential eines der Pole V+ einer Gleichspannungsquelle, und zwar durch die Aufladung der Kondensatoren $C_3$ und $C_4$, die an Masse liegen, über die Widerstände $R_2$ und $R_3$. Da auch die Emitter der Transistoren $Q_1$, $Q_2$ über die Widerstände $R_1'$, $R_1''$ und $R_1$ mit dem gleichen Pol V+ verbunden sind, sperren die Transistoren $Q_1$, $Q_2$, und die Kondensatoren $C_5$, $C_6$ werden aufgeladen. Diese Kondensatoren $C_5$, $C_6$ sind miteinander verbunden und an den durch die Widerstände $R_{10}$, $R_{10}'$ gebildeten Spannungsteiler angeschlossen, der an einem festen Potential liegt und dessen Mittelabgriff über eine Diode $D_5$ mit dem Impulseingang E bzw. dem Oszillator verbunden ist. Der zweite Zustand der Schaltung, der im folgenden aktive Stellung genannt wird, kommt vor, wenn der Impulseingang auf LOW steht. «LOW» heisst, eine Spannung wesentlich negativer als das Potential $e_1$ und $e_2$. Die Dioden $D_1$ und $D_2$ werden daher leitend. Die einen Elektroden von $C_1$ und $C_2$ fallen auf eine Spannung $e_3$ ab, wobei $e_3$ ein Potential ist, das um eine Diodendurchlassspannung höher liegt als das am Impulseingang anstehende Potential. Wegen der steilen negativen Flanke der Eingangsimpulse fliesst kurzzeitig ein relativ grosser Strom durch die Kapazitätsbrücke $C_1$, $C_3$, $C_2$, $C_4$ und die Basen der zwei Transistoren $Q_1$, $Q_2$. Diese Basisströme bewirken verstärkte Kollektorströme, die über die Widerstände $R_4$, $R_5$ entsprechende Spannungsabfälle hervorrufen, wobei die dadurch an den Kollektoren der Transistoren $Q_1$, $Q_2$ anstehenden Potentiale den Eingängen des Differenzverstärkers $OA_1$ zugeführt werden. Der sich im Augenblick des Durchschaltens ergebende Gleichtaktsprung an den Eingängen des Differenzverstärkers $OA_1$ wird durch die Kondensatoren $C_5$, $C_6$ bzw. die Widerstände $R_{10}$, $R_{10}'$ und die Diode $D_5$ gedämpft. Dabei führt der sich im Augenblick des Durchschaltens der Transistoren $Q_1$, $Q_2$ an den miteinander verbundenen Elektroden der Kondensatoren $C_5$, $C_6$ ergebende positive Spannungssprung zu einem Durchschalten der Diode $D_5$ zu dem Impulseingang E, an dem zu diesem Zeitpunkt ein LOW-Signal ansteht. Es wird vorerst angenommen, dass $C_1$ gleich $C_2$, $C_3$ gleich $C_4$ und $e_2$ gleich $e_1$ ist. In diesem Falle sind die Ladungsübertragungen auf beiden Seiten der Brücke gleich und die beiden Transistoren $Q_1$, $Q_2$ bedingen gleich grosse Potentialänderungen an den Eingängen des Differenzverstärkers, sobald sie aufgrund eines am Impulseingang anstehenden «LOW»-Signales leitend geworden sind.

Wenn $C_3$ nicht gleich $C_4$ ist und $e_2$ gleich $e_1$ ist, dann sind die Ladungsänderungen ungleich und die an den Kollektoren der Transistoren $Q_1$, $Q_2$ bzw. den Widerständen $R_4$, $R_5$ abgenommenen Potentiale werden ungleich, wodurch sich die Ausgangsspannung des Verstärkers $OA_1$ ändert. Die Schaltung verbleibt nur eine relativ kurze Zeit in diesem aktiven Zustand und die positive Flanke des Eingangsimpulses bringt die Schaltung wieder in den Grundzustand. Die Dioden $D_3$ und $D_4$ begrenzen die Invers-Emitter-Basisspannungen und durch die dazu parallel geschalteten Widerstände $R_2$, $R_3$ wird eine Auswirkung allfälliger Ungleichheiten der Kennlinien der Dioden $D_3$, $D_4$ auf das Messergebnis vermieden.

Die Impuls-Frequenz ist zweckmässig so hoch wie möglich eingestellt, und zwar mit Rücksicht auf die Zeit, welche die Schaltung benötigt, um sich auf ihren Grundzustand zu stabilisieren. Die Widerstände $R_4$ und $R_5$ sind so proportioniert, dass die Eingänge des Verstärkers $OA_1$ innerhalb seines Gleichtaktspannungsbereiches bleiben, und dass die Kollektoren der zwei Transistoren immer eine gegenüber den Emittern negative Spannung aufweisen. Die Werte $C_5$ und $C_6$ sind so gross, dass der Gleichtaktsprung nach jedem negativen Eingangsimpuls klein bleibt.

Die Zeichnung zeigt, dass eine Seite der beiden Kondensatoren $C_3$ und $C_4$ mit einem Konstantpotential, z.B. Erde, verbunden ist, d.h. $C_3$ und $C_4$ kann einen Differentialkondensator darstellen. Dies ist bei vielen kapazitiven Gebertypen der Fall. Wenn $C_1$ gleich $C_2$ ist und $C_3$ und $C_4$ einen Geber bilden, dann kann man sehr kleine Kapazitätsänderungen messen, wenn der Verstärker $OA_1$ eine hohe Leerlaufverstärkung aufweist, wobei die Schaltung durch Gegenkopplung vom Ausgang stabil gehalten wird. In diesem Zusammenhang zeigt die Erfindung bei derartigen Messwandlern erstmals die Möglichkeit der Anordnung einer lediglich durch Widerstände gebildeten Gegenkopplung auf.

Das Potential $e_1$ kann ein konstantes Potential (auch Null) sein oder von einer Rückkopplung vom Verstärker $OA_1$ gespeist werden, wenn dieser einen Differenzausgang besitzt. Weiters kann das Potential $e_1$, wie strichliert angedeutet ist, über einen mit den Widerständen $R_{30}$, $R_{31}$ beschalteten 1:1 Inverter $I_1$ vom Abgriff des Potentiometers $P_1$ gespeist sein. In letzterem Falle ergibt sich eine besonders gute Linearität zwischen der Kapazität der Kondensatoren $C_3$, $C_4$ und der Ausgangsspannung des Differenzverstärkers $OA_1$, wobei das Ausmass der Rückkopplung leicht einstellbar ist.

An Stelle der Dioden $D_1$ und $D_2$ können auch Transistoren verwendet werden, die gemeinsam mit einem – vorzugsweise aus Recheckimpulsen bestehenden – Impulszug an ihren Basen angesteuert werden, um alternierend eine Verbindung zwischen den Kondensatoren $C_2$ bzw. $C_1$ und einem festen Potential herzustellen, dessen Höhe selbstverständlich von jener der Potentiale $e_1$ und $e_2$ verschieden sein muss.

Eine weitere Abänderung der dargestellten Schaltung ist auch in der Weise möglich, dass ein Differenzverstärker $OA_1$ mit Differenzausgang verwendet wird und das Potential $e_1$ von dem zweiten der Differenzausgänge abgegriffen wird.

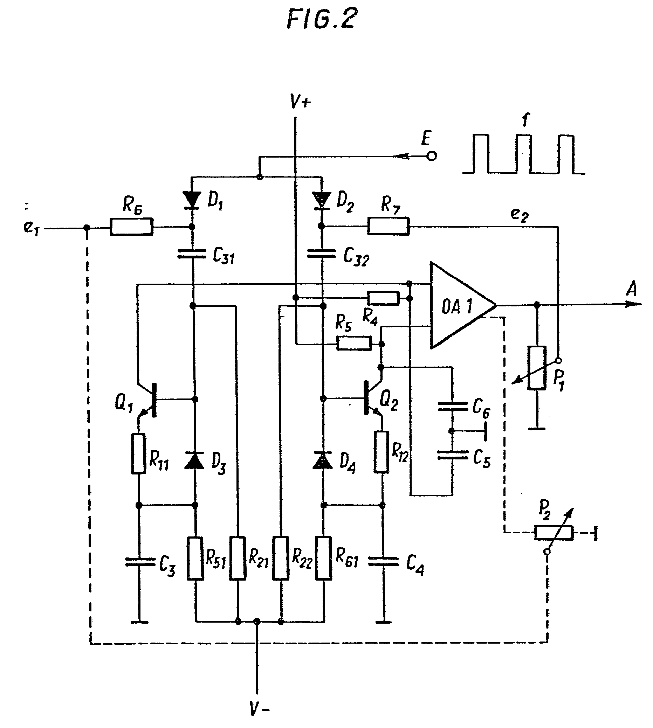

Bei der Ausführungsform gemäss Fig. 2 sind die beiden Brückenzweige durch den Kondensator $C_{31}$, den Emitterwiderstand $R_{11}$ und den Kondensator $C_3$ bzw. den Kondensator $C_{32}$, den Emitterwiderstand $R_{12}$ und den Kondensator $C_4$ gebildet. Die Transistoren $Q_1$, $Q_2$ sind dabei in die Brückenzweige als Verstärker eingeschaltet und mit ihren Kollektoren mit den Eingängen des Differenzverstärkers $OA_1$ verbunden. Die in den Hauptstromkreisen der Transistoren $Q_1$, $Q_2$ liegenden Kondensatoren $C_3$, $C_4$ sind mit Entladewiderständen $R_{51}$, $R_{61}$ verbunden, die jedoch auf einem anderen festen Potential $V-$ als diese Kondensatoren angeschlossen sind, wobei das mit den Widerständen $R_{51}$, $R_{61}$ verbundene Potential negativer ist als das an den Eingängen des Differenzverstärkers $OA_1$ anstehende Potential und so die Gleichtaktspannung an dessen Eingängen genügend weit von den Potentialen seiner Versorgungsspannung entfernt bleibt. Weiters sind die Emitter und die Basen über die Widerstände $R_{51}$, $R_{21}$ bzw. $R_{61}$, $R_{22}$ mit dem gleichen Potential $V-$ verbunden. Dabei wäre auch eine Abänderung der Schaltung möglich, nach der die Widerstände $R_{21}$, $R_{22}$ mit ihrem einen Anschluss statt mit dem Potential $V-$ mit den Widerständen $R_{11}$ und $R_{51}$ bzw. $R_{12}$ und $R_{61}$ verbunden und somit parallel zu den Dioden $D_3$ bzw. $D_4$, welche die Invers-Emitter-Basisspannung begrenzen, geschaltet wären.

Der übrige Teil der Schaltung, insbesondere die Rückkopplung des Ausganges des Differenzverstärkers $OA_1$ über das Potentiometer $P_1$ und den Widerstand $R_7$ auf den einen Brückenzweig ist identisch mit der Schaltung gemäss Fig. 1. Lediglich die zur Dämpfung des Gleichtaktsprungs an den Eingängen des Differenzverstärkers $OA_1$ vorgesehenen Kondensatoren $C_5$, $C_6$ sind direkt an ein festes Potential angeschlossen, statt über eine Diode $D_5$ an den Impulseingang E. Im übrigen ist in Fig. 2 die Möglichkeit der Rückkopplung eines Differenzausganges des Differenzverstärkers $OA_1$ auf den zweiten Brückenzweig über das Potentiometer $P_2$ strichliert angedeutet.

Das Potential des am Eingang E ankommenden Impulszuges f ändert sich zwischen Werten, die über- und unterhalb der um die Durchlassspannung der Dioden $D_1$, $D_2$ verschobenen, an den Kondensatoren $C_{31}$, $C_{32}$ liegenden Potentiale $e_1$ bzw. $e_2$ liegen.

Liegt ein negatives Potential am Eingang E an, so sperren die Dioden $D_1$ und $D_2$ und die einen Elektroden der Kondensatoren $C_{31}$, $C_{32}$ nehmen die Potentiale $e_1$ bzw. $e_2$ an, und es fliesst dann kein Strom mehr in der Schaltung, bis eine positive Flanke des Impulszuges f den Grundzustand beendet. In diesem Falle werden die Dioden $D_1$, $D_2$ leitend, und der Potentialsprung überträgt sich über die Kondensatoren $C_{31}$, $C_{32}$ auf deren mit den Basen der Transistoren $Q_1$, $Q_2$ und den Widerständen $R_{21}$ bzw. $R_{22}$ verbundene Elektroden, so dass über diese Widerstände Ströme fliessen, von denen ein Teil über die Basen der zugeordneten

Transistoren $Q_1$, $Q_2$ abfliesst und diese durchschaltet. Trotz des am Eingang E anstehenden positiveren Potentials nimmt jenes der mit den Basen und den Widerständen $R_{21}$ bzw. $R_{22}$ verbundenen Elektroden der Kondensatoren $C_{31}$ bzw. $C_{32}$ ab und anderseits steigt das Potential der mit dem zugeordneten Transistor $Q_1$ bzw. $Q_2$ über die Emitterwiderstände $R_{11}$ bzw. $R_{12}$ verbundenen Elektrode des Kondensators $C_3$ bzw. $C_4$ an, wodurch sich die Basisvorspannung der Transistoren $Q_1$, $Q_2$ vermindert und diese sperren. Die Emitterwiderstände $R_{11}$, $R_{12}$ verhindern überdies, dass die Transistoren $Q_1$, $Q_2$ in die Sättigung geraten. In jedem Fall tritt das Sperren der Transistoren $Q_1$, $Q_2$ ein, wenn eine negative Flanke des Impulszuges f am Eingang E eintrifft, da kann das Potential der einen Elektroden der Kondensatoren $C_{31}$, $C_{32}$ auf das Niveau der Potentiale e bzw. $e_2$ abfällt und sich dieser Potentialsprung auf die zweiten Elektroden und damit auf die Basen der Transistoren $Q_1$, $Q_2$ überträgt. Die Dioden $D_3$, $D_4$ begrenzen in diesem Falle die Basis-Emitter-Inversspannungen.

Bei gesperrten Transistoren $Q_1$, $Q_2$ entladen sich die Kondensatoren $C_3$, $C_4$ über die Widerstände $R_{51}$ bzw. $R_{61}$ und zu einem Teil auch über die Dioden $D_3$ bzw. $D_4$ und die Widerstände $R_{21}$ bzw. $R_{22}$, wobei auch das Potential der mit diesen Widerständen verbundenen Elektroden der Kondensatoren $C_{31}$, $C_{32}$ nach deren durch die negative Flanke des Impulszuges bedingten negativen Potentialänderung wieder angehoben wird, so dass die Schaltung rasch in ihren Grundzustand übergeht, in dem praktisch kein Strom fliesst.

Unterschiede in den über die Emitter-Kollektorstrecken der Transistoren $Q_1$, $Q_2$ fliessenden Ströme werden von dem mit diesen Strecken verbundenen Differenzverstärker $OA_1$ verstärkt. Ändert sich nun die Kapazität eines der Kondensatoren $C_3$, $C_4$ oder – falls dies die Teilkondensatoren eines Differentialkondensators sind – beider Kondensatoren, so hat dies eine Änderung der über die Emitter-Kollektorstrecken der Transistoren $Q_1$, $Q_2$ fliessenden Ströme zur Folge, wodurch sich auch das Ausgangssignal des Differenzverstärkers $OA_1$ ändert. Damit ändert sich aber auch das während des Grundzustandes der Schaltung an der einen mit der Diode $D_2$ verbundenen Elektrode des Kondensators $C_{32}$ angelegte Potential, da diese über die aus dem Widerstand $R_7$ und dem Potentiometer $P_1$ bestehende Rückkopplung mit dem Ausgang A verbunden ist. Dies beeinflusst wieder die Grösse, des durch die nächste positive Flanke des Impulszuges bedingten Potentialsprunges, welcher wieder die Grösse des in die Basis des Transistors $Q_2$ abfliessenden Basisstromes bestimmt, der seinerseits die Grösse des über die Emitter-Kollektorstrecke fliessenden Stromes bestimmt. Das an dem Kondensator $C_{31}$ während des Grundzustandes der Schaltung anliegende Potential $e_1$, mit welchem dieser Kondensator über den Widerstand $R_6$ verbunden ist, bleibt dagegen unverändert oder wird von einem zweiten Differenzausgang des Differenzverstärkers $OA_1$ abgenommen. Eine weitere Möglichkeit besteht auch darin, den Ausgang des Differenzverstärkers $OA_1$ über einen Inverter, wie in Fig. 1 strichliert dargestellt, auf den zweiten Brückenzweig rückzukoppeln.

Auf diese Weise wird die Schaltung im Gleichgewicht gehalten, wobei mit einer sehr geringen Rückkopplungsenergie das Auslangen gefunden wird, da sie ja auf den Basiskreis einwirkt.

Durch die beiden mit einem festen Potential verbundenen und parallel zu den Eingängen des Differenzverstärkers $OA_1$ liegenden Kondensatoren $C_6$, $C_5$ wird der Gleichtaktsprung an den Eingängen des Differenzverstärkers unterdrückt bzw. vermindert.

Bei der Schaltung gemäss Fig. 2 sind verschiedene Abänderungen denkbar. So könnten die Widerstände $R_6$ bzw. $R_7$ statt mit den Dioden $D_1$ bzw. $D_2$ auch mit den mit den Emitterwiderständen $R_{11}$, $R_{12}$ der Transistoren $Q_1$ bzw. $Q_2$ verbundenen Elektroden der Kondensatoren $C_3$, $C_4$ verbunden werden. In diesem Falle würde sich während des Grundzustandes der Schaltung eine von der Ausgangsspannung des Differenzverstärkers $OA_1$ abhängige Ladung des Kondensators $C_4$ ergeben, die wieder den während der aktiven Phase der Schaltung über den Transistor $Q_2$ fliessenden Strom beeinflusst. An die Kondensatoren $C_{31}$, $C_{32}$ bzw. die Dioden $D_1$, $D_2$ wären bei dieser Variante über Widerstände feste Potentiale anzulegen.

Bei der Schaltung gemäss Fig. 2 können die Kondensatoren $C_{31}$, $C_{32}$ sehr kleine Werte aufweisen, wodurch sehr kleine Zeitkonstanten möglich werden und mit Frequenzen des von einem nicht dargestellten Oszillator gelieferten Impulszuges im MHz-Bereich gearbeitet werden kann, wodurch auch sehr rasch erfolgende Kapazitätsänderungen der Messkondensatoren $C_3$, $C_4$ erfasst werden können.

Eine weitere Abänderung der Schaltung gemäss Fig. 2 wäre auch in dem Sinne möglich, dass zwischen der Basis eines jeden Transistors $Q_1$, $Q_2$ und dem zugeordneten Kondensator $C_{31}$, $C_{32}$ ein Widerstand zwischengeschaltet und unter Umständen auf die Emitterwiderstände $R_{11}$, $R_{12}$ verzichtet wird. In letzterem Falle gelangen die Transistoren $Q_1$, $Q_2$ aber leicht in die Sättigung, und es muss dann die Frequenz des ansteuernden Impulszuges bzw. die Schaltung so bemessen werden, dass die Transistoren $Q_1$, $Q_2$ so lange leitend bleiben, bis auch der grössere der Kondensatoren $C_3$, $C_4$ voll geladen ist, wobei dann der Differenzverstärker im wesentlichen auf die unterschiedliche Dauer der Ströme über die beiden Brückenzweige anspricht.

In den dargestellten Ausführungsbeispielen weisen die Brückenzweige jeweils zwei Kondensatoren auf, doch ist dies nicht unbedingt erforderlich, und es ist auch möglich, je einen davon durch Widerstände zu ersetzen.

**Patentansprüche**

1. Kapazitive Messbrückenanordnung, insbesondere für kleine Kapazitätswerte mit
- einer Messbrücke aus zwei gleichartig aufgebauten Brückenzweigen (C1, C3 und C2, C4 bzw. C31, R11, C3 und C32, R12, C4), die einander parallel geschaltet sind und jeweils einen Kondensator (C3; C4) enthalten, von denen einer oder beide veränderlich sind,
- einer Gleichspannungsquelle (V+, V−) zur Lieferung einer Versorgungsspannung,
- einem Oszillator zur Erzeugung einer Rechteckwellenspannung,
- zwei vom Oszillator gesteuerten Schaltelementen (D1, D2), in Abhängigkeit von deren Schaltzustand die Kondensatoren aus einer Stromquelle (E) geladen oder entladen werden,
- einem Differenzverstärker (OA1) zur Erzeugung eines dem Unterschied in den Ladeströmen der beiden Kondensatoren (C3; C4) entsprechenden Ausgangssignals, das dem Unterschied in den Kapazitätswerten der beiden Kondensatoren entspricht, wobei die beiden Eingänge des Differenzverstärkers mit dem Ausgang der Messbrücke in Verbindung stehen,
dadurch gekennzeichnet dass
- jedes der beiden Schaltelemente (D1, D2) in Reihe mit jeweils einem der beiden Brückenzweige (C1, C3 und C2, C4 bzw. C31, R11, C3 und C32, R12, C4) geschaltet ist,
- dass an den Verbindungspunkt jedes der Brückenzweige mit dem zugehörigen Schaltelement jeweils eine Potentialquelle (e1 bzw. e2) über jeweils ein passives Bauelement (R6 bzw. R7) angeschlossen ist, wobei die eine der Potentialquellen (e2) von einem lediglich passive Bauelemente (P1, R7) aufweisenden Rückkopplungskreis gebildet ist, der vom Ausgang des Differenzverstärkers zum betreffenden Verbindungspunkt führt, während die andere Potentialquelle (e1) einen festen Potentialwert oder ein zum Ausgangssignal des Differenzverstärkers (OA1) inverses Potential liefert, und
- dass den beiden Eingängen des Differenzverstärkers (OA1) jeweils eine Glättungsschaltung (R4, C5; R5, C6) vorgeschaltet ist.

2. Messbrückenanordnung nach Anspruch 1, dadurch gekennzeichnet, dass die Schaltelemente durch Dioden (D1, D2) gebildet sind und die Rechteckwellenspannung zwischen Werten schwankt, die über und unter den um die Durchlassspannung der Dioden (D1, D2) verschobenen Potentialen der Potentialquellen (e1, e2) liegen.

3. Messbrückenanordnung nach Anspruch 1 oder 2, dadurch gekennzeichnet, dass an den Verbindungspunkten der beiden Kondensatoren (C3, C4) mit den übrigen, vorzugsweise aus je einem weiteren Kondensator (C1, C2) bestehenden Bauteilen der Brückenzweige die Steuereingänge zweier vorzugsweise durch Transistoren (Q1, Q2) gebildeter Verstärker angeschlossen sind, welche mit ihren Ausgängen mit den Glättungsschaltungen (R4, C5; R5, C6) verbunden sind.

4. Messbrückenanordnung nach Anspruch 3, dadurch gekennzeichnet, dass die mit den Steuereingängen der Verstärker verbundenen Verbindungspunkte der beiden Brückenzweige über in Sperrichtung gepolte Dioden (D3, D4) und zu diesen parallelgeschaltete Widerstände (R2, R3) mit einem festen Potential (V+) der Gleichspannungsquelle verbunden sind.

5. Messbrückenanordnung nach Anspruch 3 oder 4, dadurch gekennzeichnet, dass die Emitter der die Verstärker bildenden Transistoren (Q1, Q2) über je einen Widerstand (R1', R1'') mit einem an einem festen Potential (V+) der Gleichspannungsquelle angeschlossenen weiteren Widerstand (R1) verbunden sind.

6. Messbrückenanordnung nach Anspruch 1 oder 2, dadurch gekennzeichnet, dass in jedem Brückenzweig ein von einem Transistor (Q1, Q2) gebildeter Verstärker angeordnet ist, der Differenzverstärker (OA1) eingangsseitig mit den Hauptstromkreisen dieser Transistoren verbunden ist, die Emitter der Transistoren (Q1, Q2) mit Widerständen (R11, R12) verbunden sind, die anderseits mit den beiden Kondensatoren (C3, C4) und mit Entladewiderständen (R51, R61) verbunden sind, und die Emitter und die Basen dieser Transistoren (Q1, Q2) über Widerstände (R51, R21; R61, R22) mit einem festen Potential (V−) der Gleichspannungsquelle verbunden sind, wobei die Basen der Transistoren (Q1, Q2) mit den Schaltelementen (D1, D2) über jeweils einen weiteren Kondensator (C31, C32) der Brückenzweige verbunden sind.

7. Messbrückenanordnung nach Anspruch 6, dadurch gekennzeichnet, dass die einen Elektroden der im Hauptstromkreis der Verstärker liegenden Kondensatoren (C3, C4) der Brückenzweige an einem gemeinsamen festen Potential liegen und dass die Entladewiderstände (R51, R61) jeweils an einem gemeinsamen festen Potential (V−) liegen, das negativer ist als jenes der Eingänge des Differenzverstärkers (OA1).

8. Messbrückenanordnung nach einem der Ansprüche 1 bis 7, dadurch gekennzeichnet, dass die Eingänge des Differenzverstärkers (OA1) mit je einem Kondensator (C5, C6) verbunden sind, wobei die beiden anderen Elektroden dieser Kondensatoren (C5, C6) gemeinsam an einem festen Potential liegen.

9. Messbrückenanordnung nach einem der Ansprüche 1 bis 7, dadurch gekennzeichnet, dass die Eingänge des Differenzverstärkers (OA1) mit je einem Kondensator (C5, C6) verbunden sind, wobei die beiden anderen Elektroden dieser Kondensatoren (C5, C6) gemeinsam an einem an einem festen Potential liegenden Potentialteiler (R10, R10') angeschlossen sind, dessen Mittelanschluss über eine Diode (D5) mit dem Oszillator verbunden ist.

10. Messbrückenanordnung nach Anspruch 1, dadurch gekennzeichnet, dass die andere Potentialquelle (e1) von einer an den Ausgang des Differenzverstärkers angeschlossenen Inverterschaltung (I1, R30, R31) gebildet ist.

**Claims**

1. A capacitance bridge circuit for the measurement of predominantly small capacitance values, comprising a bridge of two similarly configured arms (C1, C3 and C2, C4; C31, R11, C3 and C32, R12, C4, respectively) which are parallel to each other, each arm containing a capacitor (C3; C4), one or both of which is/are variable, and further comprising a d.c. voltage source (V+, V−) for delivery of a supply voltage, and an oscillator for generating a square wave voltage, and two switching elements (D1, D2) controlled by the said oscillator, the state of which elements determines whether the capacitors are being charged by a source (E) or discharged, and a differential amplifier (OA1) for producing an output signal corresponding to the difference between the charge currents of the two capacitors (C3; C4) and to the difference in the capacitance of the said capacitors – the two inputs of the said differential amplifier being connected to the output of the bridge –, wherein each of the two switching elements (D1, D2) is series-connected to one of the two bridge arms (C1, C3 and C2, C4; C31, R11, C3 and C32, R12, C4, respectively), and wherein a potential source (e1 and e2, respectively) is connected to the point of connection between each bridge arm and its corresponding switching element by means of a passive component (R6 and R7, respectively) each, one of the two sources of the potential (e2) consisting of a feedback circuit including passive components (R1, R7) only and leading from the output of the differential amplifier to the corresponding point of connection, and the other potential source (e1) supplying a fixed potential or a potential whose value is inverse to the output signal of the differential amplifier (OA1), and wherein each of the two inputs of said differential amplifier (OA1) is preceded by a smoothing circuit (R4, C5; R5, C6).

2. A bridge circuit according to claim 1, wherein the switching elements are diodes (D1, D2), and wherein the square wave voltage oscillates between values above and below those of the source potentials (e1, e2) shifted by the on-state voltage of the diodes (D1, D2).

3. A bridge circuit according to claim 1 or 2, wherein the points of connection of the two capacitors (C3, C4) and the other components of the bridge arms which preferably consist of one further capacitor each (C1, C2), are provided with the control inputs of two amplifiers preferably consisting of transistors (Q1, Q2) whose outputs are connected to the smoothing circuits (R4, C5; R5, C6).

4. A bridge circuit according to claim 3, wherein the points of connection of the two bridge arms which are connected to the control inputs of the amplifiers, are connected to a fixed potential (V+) of the d.c. voltage source by means of diodes (D3, D4) which are biased beyond cut-off, and of resistors (R2, R3) which are parallel-connected to the said diodes.

5. A bridge circuit according to claim 3 or 4, wherein the emitters of the amplifier-transistors (Q1, Q2) are connected by one resistor each (R1′, R1″) to another resistor (R1) connected to a fixed potential (V+) of the d.c. voltage source.

6. A bridge circuit according to claim 1 or 2, wherein each bridge arm is provided with an amplifier formed by a transistor (Q1, Q2), and wherein the input of the differential amplifier (OA1) is connected to the main current circuits of the said transistors, and the emitters of the transistors (Q1, Q2) are connected to resistors (R11, R12) which in turn are connected to the two capacitors (C3, C4) and to discharge resistors (R51, R61), and wherein emitters and bases of the said transistors (Q1, Q2) are connected via resistors (R51, R21; R61, R22) to a fixed potential (V−) of the d.c. voltage source, the bases of the transistors (Q1, Q2) being connected to the switching elements (D1, D2) by one further capacitor (C31, C32) of the bridge arms each.

7. A bridge circuit according to claim 6, wherein one of the electrodes of each of the capacitors (C3, C4) of the bridge arms lying in the main current circuit of the amplifiers is connected to a common fixed potential, and wherein the discharge resistors (R51, R61) are again connected to a common fixed potential (V−) which is more negative than that of the inputs of the differential amplifier (OA1).

8. A bridge circuit according to any of claims 1–7, wherein the inputs of the differential amplifier (OA1) are connected to one capacitor (C5, C6) each, the other two electrodes of the said capacitors (C5, C6) being connected to one common fixed potential.

9. A bridge circuit according to any of claims 1–7, wherein the inputs of the differential amplifier (OA1) are connected to one capacitor (C5, C6) each, the other two electrodes of the said capacitors (C5, C6) being connected to a resistor chain (R10, R10′) dividing a fixed potential, whose midpoint is connected to the oscillator by means of a diode (D5).

10. A bridge circuit according to claim 1, wherein the other potential source (e1) is formed by an inverter circuit (I1, R30, R31) which is connected to the output of the differential amplifier.

**Revendications**

1. Dispositif de pont de mesure capacitif, notamment pour de faibles valeurs de capacité, comprenant:

– un pont de mesure constitué par deux branches de pont de construction identique (C1, C3 et C2, C4, ainsi que C31, R11, C3 et C32, R12, C4) qui sont connectées en parallèle et qui contiennent chacune un condensateur (C3; C4) dont l'une ou les deux sont modifiables,

– une source de tension continue (V+, V−) pour délivrer une tension d'alimentation,

– un oscillateur pour la production d'une tension à onde rectangulaire,

– deux éléments connecteurs (D1, D2) commandés par l'oscillateur pour charger et décharger les condensateurs, à partir d'une source de courant (E) en dépendance de leur état de charge,

– un amplificateur différentiel (OA1) pour la production d'un signal de sortie correspondant à la différence de charge dans les courants de charge des deux condensateurs (C3, C4) et qui correspond à la différence entre les valeurs de capacité des deux condensateurs, les deux entrées de l'amplificateur différentiel étant en liaison avec la sortie du pont de mesure,
dispositif de pont de mesure caractérisé en ce que:

– chacun des deux éléments connecteurs (D1, D2) est monté en série avec l'une des deux branches de pont (C1, C3 et C2, C4) ainsi que (C31, R11, C3 et C32, R13, C4),

– une source de potentiel (e1 ainsi que e2) étant raccordée, par l'élément connecteur correspondant, au point de jonction de chacune des branches de pont, par l'intermédiaire d'un élément de construction passif (R6; R7) est formée par un circuit de couplage en retour, présentant simplement un élément passif (R6; R7), circuit qui s'étend de la sortie de l'amplificateur différentiel vers le point de jonction correspondant, tandis que l'autre source de potentiel (e1) délivre une valeur de potentiel fixe, ou un potentiel inverse du signal de sortie de l'amplificateur différentiel (OA1),

– les deux entrées de l'amplificateur différentiel (OA1) étant précédées chacune par un montage de nivellement (R4, C5; R5, C6).

2. Dispositif de pont de mesure suivant la revendication 1, caractérisé en ce que les éléments connecteurs sont constitués par des diodes (D1, D2) et la tension à onde rectangulaire oscille entre des valeurs qui sont situées au-dessus et au-dessous des potentiels des sources de potentiel (e1, e2) qui sont décalées de la tension de traversée des diodes (D1, D2).

3. Dispositif de pont de mesure suivant l'une des revendications 1 ou 2, caractérisé, aux points de jonction des deux condensateurs (C3, C4) avec les autres éléments de construction de la branche de pont, constitués de préférence chacun par un condensateur (C1, C2), sont raccordées les entrées de commande de deux amplificateurs formés, par exemple, par des transistors (Q1, Q2) qui sont reliés, par leurs sorties, aux montages de nivellement (R4, C5; R5, C6).

4. Dispositif de pont de mesure suivant la revendication 3, caractérisé en ce que les points de jonction des deux branches de pont qui sont reliés avec les entrées de commande des amplificateurs sont reliés, par l'intermédiaire de diodes (D3, D4) polarisées en direction de traversée et de résistances (R2, R3) connectées en parallèle avec celles-ci, à un potentiel fixe (V+) de la source de tension continue.

5. Dispositif de pont suivant l'une des revendications 3 ou 4, caractérisé en ce que les émetteurs des transistors (Q1, Q2) qui forment les amplificateurs sont reliés chacun, à travers une résistance (R1', R1''), à une autre résistance (R1) qui est raccordée à un potentiel fixe (V+) de la source de tension continue.

6. Dispositif de pont suivant l'une des revendications 1 ou 2, caractérisé en ce que, dans chaque branche de pont, est disposé un amplificateur, formé par un transistor (Q1, Q2), l'amplificateur différentiel (OA1) étant relié par son entrée, aux circuits de courant principal de ces transistors, les émetteurs des transistors (Q1, Q2) étant reliés à des résistances (R11, R12) qui sont reliées, d'autre part, aux deux condensateurs (C3, C4) et qui sont connectées en série avec des résistances de décharge (R51, R61), les émetteurs et leurs bases de ces transistors (Q1, Q2) étant reliées, par l'intermédiaire de résistances (R51, R21; R61, R22) à un potentiel fixe (V−) de la source de courant continu, auquel cas les bases des transistors (Q1, Q2) sont reliées aux éléments connecteurs (D1, D2) par l'intermédiaire, chacune, d'un autre condensateur (C31, C32) de la branche de pont.

7. Dispositif de pont de mesure suivant la revendication 6, caractérisé en ce que l'une des électrodes des condensateurs (C3, C4) de branche de pont montés dans le circuit de courant principal des amplificateurs, sont à un potentiel fixe commun, et les résistances de décharge (R51, R61) sont chacune à un potentiel fixe commun (V−1) qui est davantage négatif que chacune des entrées de l'amplificateur différentiel (OA1).

8. Dispositif de pont de mesure suivant l'une quelconque des revendications 1 à 7, caractérisé en ce que les entrées de l'amplificateur différentiel (OA1) sont reliées chacune à un condensateur (C5, C6), les deux autres électrodes de ces condensateurs étant reliées en commun à un potentiel fixe.

9. Dispositif de pont de mesure suivant l'une quelconque des revendications 1 à 7, caractérisé en ce que les entrées de l'amplificateur différentiel (OA1) sont reliées chacune à un condensateur (C5, C6), les autres électrodes de ces condensateurs étant raccordées chacune à un diviseur de potentiel (R10, R10') placé à un potentiel fixe, et dont la borne médiane est reliée, par l'intermédiaire d'une diode (D5), à l'oscillateur.

10. Dispositif de pont de mesure suivant la revendication 1, caractérisé en ce que l'autre source de potentiel (e1) est constituée par un montage inverseur (R1, R30, R31) qui est raccordé à la sortie de l'amplificateur différentiel (OA1).

# FIG.1

# FIG.2